# EUROPEAN PATENT SPECIFICATION

(11) **EP 1 093 503 B1**
(45) Date of publication and mention of the grant of the patent: **02.10.2002**
(21) Application number: 99904058.7
(22) Date of filing: 08.01.1999
(51) Int. Cl.: C09J 9/02

(54) **FINE PITCH ANISOTROPIC CONDUCTIVE ADHESIVE**
ANISOTROP LEITENDER KLEBSTOFF FÜR FEINEN KONTAKTABSTAND
ADHESIF CONDUCTEUR ANISOTROPE COMPRENANT DES PARTICULES DISPOSEES SELON UN ESPACEMENT SERRE

(30) Priority: 30.06.1998 US 108158
(43) Date of publication of application: 25.04.2001
(73) Proprietor: MINNESOTA MINING AND MANUFACTURING COMPANY, St. Paul, Minnesota 55133-3427 (US)
(72) Inventor: CONNELL, Glen, Saint Paul, MN 55133-3427 (US); CARPENTER, Barry, S., Saint Paul, MN 55133-3427 (US); HOGERTON, Peter, B., Saint Paul, MN 55133-3427 (US); YAMAGUCHI, Hiroaki, H., Saint Paul, MN 55133-3427 (US)
(74) Representative: von Kirschbaum, Alexander, Dipl.-Ing.
(86) International application number: US9900460
(87) International publication number: WO00000563

(56) References cited:
- EP-A- 0 330 452
- WO-A-97/12503
- US-A- 5 240 761

## Description

### Field of the Invention

The present invention relates to anisotropic conductive adhesives and methods of making anisotropic conductive adhesives.

### Background of the Invention

Conductive adhesives often provide a convenient and useful way to bond and electrically connect electrode pads on separate circuits or between layers of a multiple layer circuit. When many independent electrode pads exist in a relatively small area, it is useful to employ an anisotropic conductive adhesive, also known as a z-axis conductive adhesive. An anisotropic conductive adhesive allows conduction between opposing electrodes through the adhesive, but does not allow conduction in the plane of the adhesive. Thus, adjacent electrode pads meant to conduct independently can remain electrically isolated from each other while being bonded and electrically connected to partner electrodes on opposing circuits or circuit layers.

One method of making a conductive adhesive involves dispersing conductive particles randomly in an adhesive layer. The adhesive so formed is placed between circuit layers that are then properly aligned. When the circuit layers are pressed together, the conductive particles disposed between the pairs of opposing electrodes make contact with the electrode pads. Single particles may contact both the upper and lower electrode, or contact may be made through a series of particles creating a vertically conductive pathway through the adhesive layer. Additionally, the adhesive itself mechanically bonds the circuit layers and insulates the conductive particles so that adjacent electrodes do not electrically short. An example of such an adhesive is disclosed in U.S. Pat. No. 4,113,981 (Fujita et al.).

Difficulties arise when higher density connections are desired. Higher density connections involve smaller spacings between electrodes as well as smaller electrode pads. Using z-axis conductive adhesives to connect such "fine pitch" circuits can lead to electrical shorts between adjacent electrodes. As the distance between adjacent electrodes approaches the average spacing between conductive particles in the adhesive, isolated groups of contacting conductive particles (either "clusters" -- groups having a vertical dimension, or "strings" -- horizontal groups) can bridge the gap between adjacent electrodes, thereby shorting the circuit. One solution to this problem is to use a lower loading volume of conductive particles in the adhesive. However, in so doing, the reliability of electrode connections may suffer due to the existence of fewer particles per connection, especially in cases where very small electrode pads are used. Fewer conductive particles also increases the resistance of the circuit connection and decreases its current carrying capacity. In addition, reducing the particle loading volume does not completely address the problem of shorting due to particle grouping.

One technique to combat shorting is disclosed in U.S. Pat. No. 5,180,888 (Sugiyama). In that case, conductive particles were provided with a non-conductive coating and dispersed in an adhesive. In this way, particle strings will not form conductive pathways. Instead, the only particles that will conduct are those particles sandwiched between opposing electrodes which are pressed together with enough force to crack the non-conductive coating.

Conductive particles have also been supplied in a two-layer adhesive system where one layer contains particles and the other layer is free of particles. This method was described in an article by Watanabe et al. entitled "Anisotropic Conductive Adhesive Films for Flip-Chip Interconnection," Proceedings of the 9^{th} International Microelectronics Conference (Japan, 1996). During circuit layer bonding, the particles between electrodes are sandwiched by the electrodes, thus making electrical contact, while the excess adhesive from the particle-free second adhesive layer is pushed out from between the electrodes and acts to clear particles out of the areas where shorts may occur. However, particle strings can still form in this method due to the random particle dispersion in the first adhesive layer, and thus shorts can still occur.

The problems associated with electrical shorting due to particle strings have been addressed in other ways. One way is to separate randomly dispersed particles. This may be done mechanically or magnetically. In U.S. Pat. No. 5,240,761 (Calhoun et al.), conductive particles are randomly dispersed on a stretchable adhesive layer and the adhesive is biaxially stretched to separate each particle from its neighbors. In U.S. Pat. No.4,737,112 (Jin et al.), magnetic particles are randomly dispersed in an adhesive layer so that, upon application of a magnetic field perpendicular to the adhesive layer, the -particles repel each other. Each of these methods serve to reduce the risk of particle strings or particle clumping that may lead to electrical shorts, but they do not eliminate the possibility. The reduced risk of electrical shorting, however, comes at the expense of a lower particle density.

Another way to separate particles is to form ordered arrays of particles. Ordered array conductive adhesives fall into two categories: ordered single particle adhesives and ordered cluster adhesives. Single particle adhesives arc z-axis conductive adhesives that contain a single layer of particles so that each particle connecting opposing electrode pads contacts both the upper and lower electrode pad. Cluster adhesives are z-axis conductive adhesives that contain separated clusters of conductive particles.

Ordered single particle adhesives may be formed by mechanically ordering the conductive particles or by magnetically ordering the conductive particles. U.S. Pat. No. 5,300,340 (Calhoun et al.) discloses mechanically ordering conductive particles onto an adhesive layer. The process includes rotating a drum covered with a periodic array of rubber dots through a fluidized bed of electrically conductive spherical particles about the size of the rubber dots. The particles adhere to the rubber dots and any excess particles on the drum are suctioned off. This leaves conductive particles only on the periodic array of rubber dots. The periodic array of particles is ultimately transferred onto the adhesive side of a pressure sensitive adhesive tape. The diameters of the conductive particles are about equal to or somewhat larger than the thickness of the adhesive layer. The result is an adhesive layer on a backing, the adhesive layer embedded with an ordered array of single conductive particles.

U.S. Pat. No. 5,616,206 (Sakatsu et al.) also discloses the mechanical ordering of single layer particle arrays. In this process, a mask containing a periodic array of equally-sized holes is placed onto a transfer surface. Then, conductive particles, all having about the same size, are swept across the mask. The diameter of the particles is about the thickness of the mask, and a specified number of particles fits into each hole. Removal of the mask exposes the transfer surface having an ordered single layer of conductive particles. However, this ordered layer of particles is not transferred onto an adhesive layer to form a z-axis conductive adhesive. Rather, a separate adhesive layer is formed on each electrode pad of a circuit layer. The circuit layer is then brought down on the conductive particles so that each adhesive layer of each electrode contacts a portion of the conductive particles. Particles adhere to each of the adhesive layers, and the circuit layer is ready to be electrically connected to a second circuit. Because the mask must be as thin as the particles, this method is not amenable to very small particles, especially those smaller than 10 or 20 µm in diameter. A mask that thin cannot be expected to have the mechanical properties required to keep the particles in place.

U.S. Pat. No. 5,221,417 (Basavanhally) discloses magnetic ordering of conductive particles to make an anisotropic conductive adhesive. First, a matrix array of mutually isolated ferromagnetic elements is formed on a substrate and the elements are magnetized. Next, a single layer of ferromagnetic conductive particles is adhered to the ferromagnetic elements. The particles thus form a single layer array of ordered particles deposited only where the ferromagnetic elements are positioned. Next, an adhesive layer is brought into contact with the ordered single particle layer. The particles adhere to the adhesive layer to form an ordered single particle conductive adhesive. This method is limited to magnetic particles. In addition, there is still a risk of creating particle strings in the adhesive, especially when smaller particles or smaller particle spacings are desired.

Ordered particle-cluster conductive adhesives are made by forming clusters of conductive particles, placing the conductive clusters in an ordered array, and adhering the clusters to an adhesive layer. U.S. Pat. No. 5,087,494 (Calhoun et al.) discloses taking a flexible carrier film having a pre-fabricated pattern of pockets and filling the pockets with conductive particles. The particles reside solely in the pockets and not in the areas between the pockets. The particles in the pockets may also be bound together with a binder material. An adhesive layer is then formed on the carrier film over the particle-filled pockets. The adhesive may then be adhered to one surface of a circuit layer. The carrier film is then removed and an opposing circuit layer is aligned and applied on top of the first circuit layer, adhesive, and conductive particle clusters. With the application of pressure, the conductive particles are forced through the adhesive until electrical contact is made with opposing electrodes on both circuits. The application of pressure may also work to "flatten" the particle cluster so that the conductive pathway between opposing electrodes is through a group of adjacent particles in a single layer. However, conductive pathways may also be through multiple particles in a vertical grouping.

EP-A-0 330 452 discloses a conductive adhesive having conductive particles on a adhesive layer. The size of the conductive particles Is specified to be greater than the thickness of the layer.

U.S. Pat. No. 5,637,176 (Gilleo et al.) discloses a method of making an ordered z-axis conductive sheet material. The conductive sheet includes a dielectric carrier sheet having a series or array of through holes and an adhesive containing conductive particles disposed in the through holes. The conductive sheet may be formed by first forming separated columns of conductive particle-containing adhesive and then forming a dielectric film around the columns. Alternatively, the conductive sheet may be formed by taking a dielectric sheet having pre-fabricated holes and forcing adhesive spheres containing conductive particles into the holes of the dielectric sheet. The resulting conductive sheet is not an anisotropic conductive adhesive per se, but rather a series or array of isotropic conductive adhesives separated by a dielectric film matrix.

As the electrode pattern pitch on circuits becomes finer and finer, the concerns over electrical shorts between electrodes due to particle strings or clusters in the conductive adhesive becomes greater. The pitch of an electrode pattern can become finer by reducing the gap between electrodes, reducing the size of the electrode pads, or both. When using a z-axis conductive adhesive, the size of the conductive particles, the possibility of extended particle strings or clusters, and the density of particles in the adhesive all place limits on the fineness of the electrode pattern pitch. Large particles and particle strings and clusters place a lower limit on the separation between electrode pads, while the density of conductive particles places a lower limit on the size of the electrode pads. Therefore, a need exists in the art for a single particle layer z-axis conductive adhesive that ensures no extended particle strings, allows the use of small conductive particles, and provides maximum particle loading for the desired particle spacing.

In addition to these dimensional considerations, limitations on the type of particle that can be used in the conductive adhesive may also affect the reliability of the electrical connection. For example, when ferromagnetic particles are required, the preferred particles are solid metal particles. Solid metal ferromagnetic particles are hard and will not deform under pressures used to laminate circuit layers together. This is important because, if there are any variations in size among the particles, the larger particles that first make contact between a pair of electrodes may prevent smaller particles from making contact between other pairs of electrodes. However, if deformable metal particles can be used, or deformable polymeric particles coated with a metal can be used, the pressure used to laminate the circuit layers will tend to deform the larger particles that make first contact, thereby allowing smaller particles to also make contact and ensuring the reliability of all the connections across the circuit.

It is the main object of the invention to provide an anisotropic conductive adhesive forming connecting circuit layers that are free from electrical shortings.

This and other objects are solved by the features according to claim 1 and 6, re spectively.

### Summary of the Invention

The anisotropic conductive adhesive of the present invention addresses these problems, especially for fine pitch circuits (those employing electrode spacings and electrode pads with dimensions measured in hundreds of micrometers or less). The present invention provides an anisotropic conductive adhesive having a predetermined pattern of conductive particles in a single layer. The placement of the particles is mechanically constrained so that no extended particle strings can form. Thus, the spacing between circuit electrodes may approach the size of the particles in the adhesive. In addition, because the particles are arranged in an ordered pattern, the particle density remains high enough to accommodate very small electrode pads.

In one aspect, the present invention provides an anisotropic adhesive made up of an adhesive layer having a substantially uniform thickness and a plurality of conductive particles. The conductive particles have sizes that are at least somewhat smaller than the thickness of the adhesive layer. The particles are each adhered to the adhesive layer, and are arranged in a periodic array of particle sites. A substantial proportion of the particle sites has no more than a pre-determined maximum number of particles, the particles in any particular particle site being arranged in close proximity. Preferably, a substantial proportion of the particle sites also contain at least a pre-determined minimum number of particles. More preferably, a substantial proportion of the particle sites contain the same pre-determined number of particles.

In another aspect, the present invention provides an anisotropic conductive adhesive tape including a release liner, conductive particles having a thickness as described above and an adhesive layer. The release liner has surface characterized by a plurality of dimples, each dimple having a predetermined width, length, and depth, the depth of each dimple being about the same. The conductive particles reside in the dimples in a single layer, and the areas of the release liner between the dimples are substantially free of conductive material. The adhesive layer is on the side of the release liner having the dimples and contacts the conductive particles so that the particles individually adhere to the adhesive layer. When the adhesive layer is removed from the release liner, it carries with it the conductive particles.

According to a method of making the anisotropic conducting adhesive of the present invention, the first step is for example to provide a tool having a low adhesion surface characterized by a plurality of dimples, each dimple having a length, a width and a depth, wherein the dimples have substantially the same depth. Optionally, the tool may be a release liner which is capable of being re-used or remaining with the adhesive as a backing. Next, the conductive particles are placed in the dimples in such a way that the conductive particles form a single layer in the dimples. Any conductive particles residing on the tool in areas between the dimples are removed. Finally, an adhesive layer is formed on the low adhesion dimpled surface of the tool such that the conductive particles in the dimples adhere to the adhesive layer. The adhesive layer is capable of being removed from the tool, carrying with it the conductive particles. Optionally, the adhesive may be laminated to a backing film having a low adhesion surface so that the anisotropic conductive adhesive may be handled or rolled up for convenient use, shipment and storage.

The present invention also covers a method for making an electrical connection between separate circuit layers using the anisotropic conductive adhesive of the present invention. First, two circuit layers are provided having corresponding electrode patterns. Then the anisotropic conductive adhesive of the present invention is adhered to one of the circuit layers. Next, the second circuit layer is aligned and positioned in contact with the conductive adhesive on the first circuit layer. Finally, pressure is applied to the circuit layers to push the conductive particles through the adhesive layer until contact is made between the electrode pairs through the conductive particles of the anisotropic conductive adhesive.

### Brief Description of the Drawings

Fig. 1(a) is a top view of the anisotropic conductive adhesive of the present invention.
Fig. 1(b) is a cross-sectional view of the conductive adhesive shown in Fig. 1(a) taken along line 1b.
Figs. 2(a) and (b) are cross-sectional views of anisotropic conductive adhesive tapes.
Fig. 3(a) is a schematic representation of one embodiment of the anisotropic conductive adhesive of the present invention.
Fig. 3(b) is a cross-sectional view of the conductive adhesive shown in Fig. 3(a) taken along line 3b.
Fig. 4 is a schematic representation of a process of making the anisotropic conductive adhesive according to the present invention.
Figs. 5(a) through (c) are schematic representations of the steps of electrically connecting two circuit layers according to the present invention.
Figs. 6(a) through (e) are micrographs of various particle arrangements according to the present invention.

### Detailed Description

### A. Anisotropic Conductive Adhesive

### First Embodiment

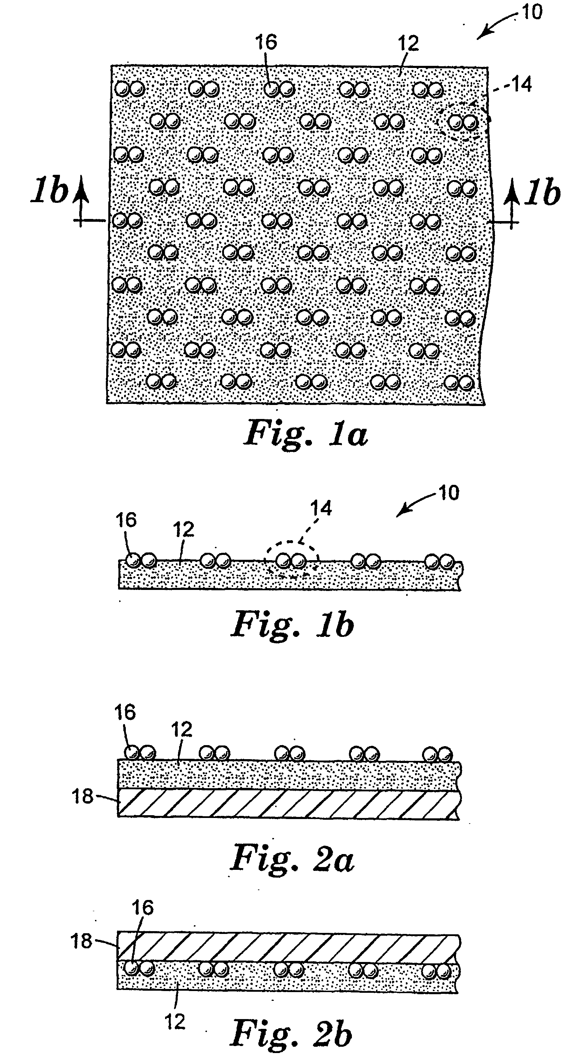

Fig. 1(a) shows a top view of one embodiment of the anisotropic conductive adhesive of the present invention. Anisotropic conductive adhesive 10 includes an adhesive layer 12 and conductive particles 16 adhered to adhesive layer 12. Conductive particles 16 are arranged in particle sites 14. Aside from conductive particles 16, adhesive layer 12 is substantially free of conductive material.

Each particle site 14 contains zero or more particles. When more than one particle resides in a particle site, the particles reside in close proximity to other particles, preferably touching other particles. Particle sites 14 are arranged in a periodic array across adhesive layer 12. In the case of Fig. 1(a), particle sites 14 each contain two adjacent particles, and the particle sites are arranged in a hexagonal array. The use of two particles per particle site with the particle sites arranged in a generally hexagonal array serves merely an illustrative purpose and does not limit the scope of the present invention or of its recited claims.

Particle sites may contain any number of discrete particles. Preferably particle sites contain ten or fewer particles, more preferably five or fewer particles. However, all particle sites need not contain the same number of particles. Rather, the desired number of particles per particle site is chosen as a maximum number of particles per particle site. A substantial proportion of the particle sites contains the maximum number of particles or fewer. Occasionally, a particle site will contain one or two (or more) extra particles within its boundaries. Preferably 80% or more of the particle sites contain the pre-determined maximum number of particles or fewer. It may also be preferable to choose a minimum number of particles per particle site. In such cases, a substantial proportion of the particle sites should contain at least the specified minimum number of particles. Preferably 80% or more of the particle sites contain the minimum number of particles, if a minimum is specified. In addition, it may be desirable to specify an exact number of particles per particle site. When such is the case, the occasional particle site may contain more or fewer particles than the desired number. Preferably, a substantial proportion of the particle sites contain the desired exact number of particles. More preferably, at least 75% of the particle sites contain the desired exact number of particles, when an exact number is specified.

Preferably, the desired number of particles per particle site is more than one particle. Multiple particles provide redundancy as insurance against the occasionally missing or abnormally small particles that may lead to the risk of an unreliable electrode connection. However, because the pitch of the electrode patterns on the circuits to be connected depends on the size and number of particles in the particle sites, the desired number of particles per site is preferably less than ten, more preferably less than five, and most preferably less than three.

The particle sites may be arranged in any ordered two-dimensional pattern. The particle sites are preferably arranged in a regular two-dimensional array, of which rectangular, square, and hexagonal are special cases. The particle sites in an array need not be the same size. In other words, the desired number of particles per particle site may vary from site to site. When such is the case, the desired number of particles varies from site to site in an ordered fashion. For example, the particle sites may be arranged in a square array where the desired number of particles per particle site alternates between two and four on adjacent sites. The desired spacing between particle sites will depend on the electrode patterns on the circuits to be bonded. For example, in fine pitch applications, the spacing between particle sites may be in the range of less than 5 µm to more than 50 µm with particle sizes of less than 1 µm to about 5 µm or 10 µm. The particle site spacing is limited only by the electrode pattern, the desired number of particles per site, and the average particle size.

Each conductive particle is individually adhered to the adhesive layer so that there is no more than one conductive particle in any given column perpendicular to the adhesive layer. This ensures that each conductive pathway between circuit electrodes is through a single particle, as is discussed in Section C below.

As shown in the cross-section of Fig. 1(b), the size of conductive particles 16 is at least somewhat smaller than the thickness of adhesive layer 12. This provides extra adhesive layer material that may be pushed into the voids between electrodes during bonding, the advantages of which are described below in Section C. Particle size is typically measured by diameter, in the case of spherical particles, or by average diameter, in the case of irregularly-shaped particles. Preferably, each conductive particle is about the same size and roughly spherical. The desired average particle size will range depending on the application. Taking into consideration the spacing between electrodes on the circuits to be bonded and the desired maximum number of particles per particle site, the average particle size can be determined. For example, if a 50 µm electrode pitch is used, and each particle site has two particles, the. desired average particle size may be anywhere in a range from less than 1 µm to more than 10 µm. The number of particles per particle site multiplied by the average size of the particles should be at least somewhat less than the spacing between electrodes on the circuits.

The conductive particles may be made of any conductive material or of any material having a contiguous conductive coating. Depending on the application, the conductive particles may be deformable and made of either a deformable metal or of a deformable core particle coated with a contiguous conductive coating. However, in some applications, hard non-deformable particles, such as Ni or Ni-coated metal particles for example, may be desired.

Adhesive 12 may be any adhesive that may be formed into a film. Preferably, the adhesive layer is either softer than the conductive particles at room temperature or becomes softer than the conductive particles upon the application of pressure and/or heat. In this way, the adhesive may be at least somewhat deformable or flowable upon the application of pressure, heat, or both. For example, the adhesive may be an epoxy-based heat curable adhesive. The adhesive may also be a thermoplastic-based adhesive. Whereas the adhesive chosen will depend on the particular application, properties that may be taken into consideration include the flowability of the adhesive upon the application of heat and/or pressure, the creep resistance of the adhesive, and the high temperature properties of the adhesive.

Useful adhesive compositions include those described in U.S. Pat. Nos. 5,143,785 (Pujol et al.), 5,330,684 (Emori et al.), 5,362,421 (Kropp et al.), and 5,457,149 (Hall et al.) These patents describe adhesive compositions formulated to be one-part, curable materials formable into pliable films having low or no tackiness before cure. After cure, these adhesive films possess moderate to high glass transition temperatures (T_{g}) in the range of about 100 to 140 °C. These adhesives also possess relatively high peel and shear strengths on a wide range of substrates. Typically these adhesives are pre-applied to one substrate using a few seconds exposure to heat and pressure, and then a second substrate is aligned and pressed against the first substrate and the adhesive is cured under heat and pressure. Typical cure conditions for these adhesives are 150 to 200 °C for 5 to 20 seconds.

Preferred film adhesive compositions include thermoset-thermoplastic blends. Thermoset resins useful in such blends include epoxies and cyanate-esters, as well as acrylates and methacrylates, urethanes, polyimides, and others. Useful thermoplastics include phenoxy, polyester, polyvinyl butyral, polysulfone, polycarbonate and others. Generally, these blends include a curative or catalyst for the thermoset resin. Epoxies may be cured either with amines, imidazoles or organometallic salts. Similar organometallic salts have also been used for cyanate ester trimerization. Other useful adhesive compositions include, for example, blends of liquid and solid thermosetting resins, or simple hot-melt systems.

An optional backing film may be added to the anisotropic conductive adhesive of the present invention for convenient handling and storage. Fig. 2(a) shows backing film 18 laminated to the non-particle side of adhesive layer 12. Conversely, backing film 18 may be laminated to the particle side of adhesive layer 12. As shown in Fig. 2(b), laminating a backing film to the particle side of the adhesive layer tends to embed conductive particles 16 in adhesive layer 12. The optional backing film can be any backing film or release liner suitable for laminating to the chosen adhesive layer and capable of being removed from the adhesive layer at some later time without also removing the conductive particles. Preferably, the optional backing film has a low adhesion surface on both faces so that, once laminated to the adhesive layer, the backing film and adhesive layer can be rolled up together in a form convenient for handling, storage, and later use.

### Second Embodiment

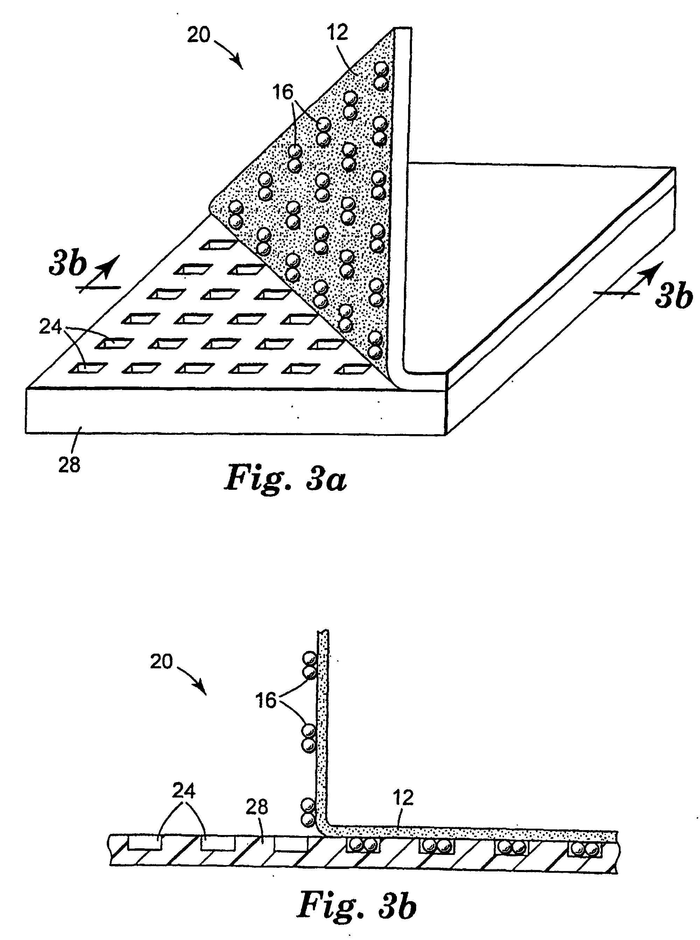

In another embodiment, the anisotropic conductive adhesive of the present invention includes a structured release liner. Figs. 3(a) and (b) show conductive adhesive construction 20 including optional release liner 28 as well as conductive particles 16 and adhesive layer 12.

Optional release liner 28 is a film having a series of dimples 24 on one face. The process for forming dimples 24 into liner 28 will be described below in Section B. While Figs. 3(a) and (b) show rectangular dimples arranged in a periodic rectangular array on the release liner, the dimples may be any desired shape and arranged in any desired pattern. The shapes and patterns of dimples shown and described are merely illustrative and are in no way meant to limit the scope of the present invention or of the recited claims. However, for reasons that shall become clear below, it is important that the dimples have substantially the same depth. The release liner itself is preferably flexible so that it is capable of being peeled off the adhesive layer. To give the release liner its release properties, at least the face of the release liner containing the dimples is a low adhesion surface, and preferably both faces of the release liner are low adhesion surfaces.

Conductive particles 16 are positioned in dimples 24 of optional release liner 28. The areas on the face of the release liner between the dimples are preferably substantially free of conductive particles 16 or other conductive material. The particles reside in the dimples in a single layer. Preferably, the size of the particles is about the same as the depth of the dimples so that the dimples can only be filled with a single layer of particles. It is desirable to have a single layer of particles so that when the conductive adhesive is used to make electrical contact between opposing electrode pads, every conductive pathway between the pads is a single conductive particle, although multiple single particle pathways exist for each electrode connection. This reduces the number of contact surfaces per pathway that may increase the resistance of the total conductive pathway.

The conductive particles are preferably about the same size. If particles exist that are significantly larger than other particles, there is the possibility that the larger particles will prevent the smaller particles from making electrical contact with both electrodes in an electrode pair. The conductive particles may be made of any conductive material or may be made of solid or hollow insulating material coated with a conductive material. Optionally, the conductive particles may be at least somewhat deformable under pressure and/or heat. Deformable particles allow greater tolerance for size variations because when larger particles make first contact between electrodes, the particles may be compressed under pressure or heat to allow smaller particles to also make contact with both electrodes in an electrode pair.

Adhesive layer 12 is formed on top of optional release liner 28 and contacts conductive particles 16. The conductive particles individually adhere to the adhesive layer so that when the adhesive layer is removed from the release liner, the conductive particles remain with the adhesive layer, as shown in Figs. 3(a) and (b). The adhesive layer preferably has a substantially uniform thickness. The adhesive layer should be at least somewhat flowable, or at least softer than the conductive particles, so that when circuit layers are pressed together with the conductive adhesive between them, the conductive particles will be pushed through the adhesive layer to ultimately make contact with electrodes on both circuit layers. The adhesive layer may or may not require the application of heat to adequately soften the adhesive for penetration of the conductive particles during circuit layer bonding.

### B. Method of Making the Conductive Adhesive of the Present Invention

To make the anisotropic conductive adhesive of the present invention, conductive particles are positioned in discrete numbers and placed in an ordered array. The particles are placed in an ordered array by mechanically constraining them in an ordered array of dimples having a chosen size. The first step is to provide a tool having a plurality of such dimples arranged in a periodic array. The dimples in the tool ultimately define the particle sites of the conductive adhesive. The dimples are all about the same depth, which preferably corresponds to the average size of the conductive particles so that only one layer of particles can reside in any given dimple. The width and length of the dimples is determined by the size of the particles and the number of desired particles per particle site. The dimpled surface of the tool is preferably a low adhesion surface, for reasons discussed below.

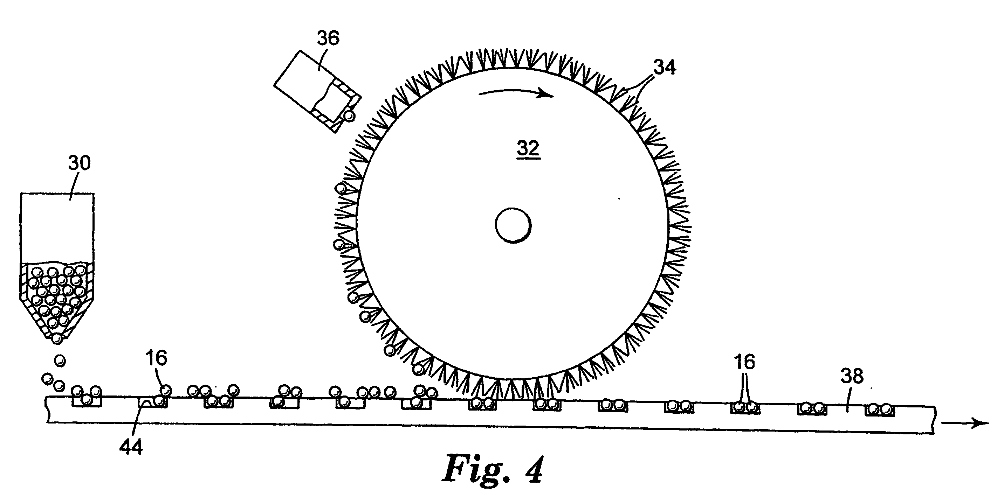

The next step is to fill the dimples with conductive particles and at the same time remove those conductive particles residing on areas of the tool other than in the dimples. Fig. 4 shows a preferred method for filling the dimples and removing the excess particles. Tool 38 having ordered array of dimples 44 is advanced past particle dispenser 30 which randomly deposits conductive particles 16 onto the dimpled surface of the tool. The conductive particles chosen should be about the same size as the depth of the dimples. This ensures that only a single layer of particles can fill each dimple. Preferably, the particles are substantially spherical to provide uniformity and easy of handling. As discussed above, the particles are preferably substantially the same size. However, the tolerance for size variation among particles increases when deformable particles are used.

The tool may be a series of rigid plates attached to a rotating belt or to the surface of a rotating drum so that the process of advancing the tool is continuous. Alternatively, the tool may be a flexible film that is either attached to a belt or a drum (and thus reused) or supplied from a roll so that the film stays with the conductive adhesive as a liner (discussed further below).

As tool 38 passes particle dispenser 30, conductive particles 16 are dispensed to substantially cover the surface of the tool. Particles 16 fall onto tool 38 in a random fashion, some particles filling the dimples, some particles residing in areas between the dimples, and some particles residing on top of other particles. Tool 38 and particles 16 advance to drum 32. Drum 32 is equipped with brushes 34 that sweep the surface of tool 38 as it passes. Drum 32 rotates opposite the advancement direction of tool 38. The . direction of motion for the drum and the tool are indicated by arrows in Fig. 4. The length and stiffness of brushes 34 are chosen depending on the size and type of conductive particles used. Smaller particles require smaller brushes, and heavier particles may require stiffer brushes. As tool 38 passes by brushes 34, the brushes sweep particles 16 into dimples 44. thereby filling the dimples. The brushes also remove the particles from the areas between the dimples. Excess particles are either pushed back onto the unswept advancing portion of the tool or picked up by the brushes. Optional suction device 36 may be positioned above drum 32 to remove excess particles picked up by the brushes.

When the dimples of the tool have been filled with conductive particles, and any conductive particles residing in areas of the tool between the dimples have been substantially removed, the adhesive layer may be applied. The adhesive layer is applied on the dimple side of the tool to substantially cover the width of the tool and to adhere to the particles. Preferably, the adhesive layer has a substantially uniform thickness. The adhesive layer may be applied by any conventional methods such as laminating an adhesive layer on top of the tool and the particles, or by applying an adhesive material as a liquid on the tool and particles and curing the adhesive on the tool. However the adhesive layer is applied, the particles individually adhere to the adhesive layer so that when the conductive adhesive is removed from the tool, the conductive particles remain with the adhesive layer.

After supplying the adhesive layer, an optional backing film may be laminated to the conductive adhesive. As shown in Figs. 2(a) and (b), the backing film may be laminated to the non-particle side of the adhesive layer or to the particle side of the . adhesive layer. The face of the backing film is preferably a low adhesion surface so that the conductive adhesive can be easily removed for use at some later time. If the backing film has low adhesion surfaces on both faces, the conductive adhesive may be rolled up with the backing film in a form convenient for storage, shipment, and later use.

Alternatively, as mentioned above, the tool itself may be made of a flexible film material having a low adhesion surface, thus acting as a release liner for the conductive adhesive. A release liner material may be provided with an ordered array of dimples by means including embossing a pre-made film or extruding and hardening a liquid resin material. In either method, a master tool having an ordered array of bumps is employed. The bumps on the master tool are then replicated into the liner as dimples either by direct embossing or by hardening of the liquid resin material around the bumps. When a release liner is used as the dimpled tool, the adhesive layer may either be removed from the release liner during processing so that the release liner may be reused, or remain with the release liner so that the release liner acts as a backing film for the conductive adhesive.

### C. Electrically Connecting Circuit Layers

Once assembled, the anisotropic conductive adhesive of the present invention is in a convenient form for handling and use. In application, the anisotropic conductive adhesive of the present invention is useful for electrically connecting two circuits or circuit layers having aligned electrode patterns.

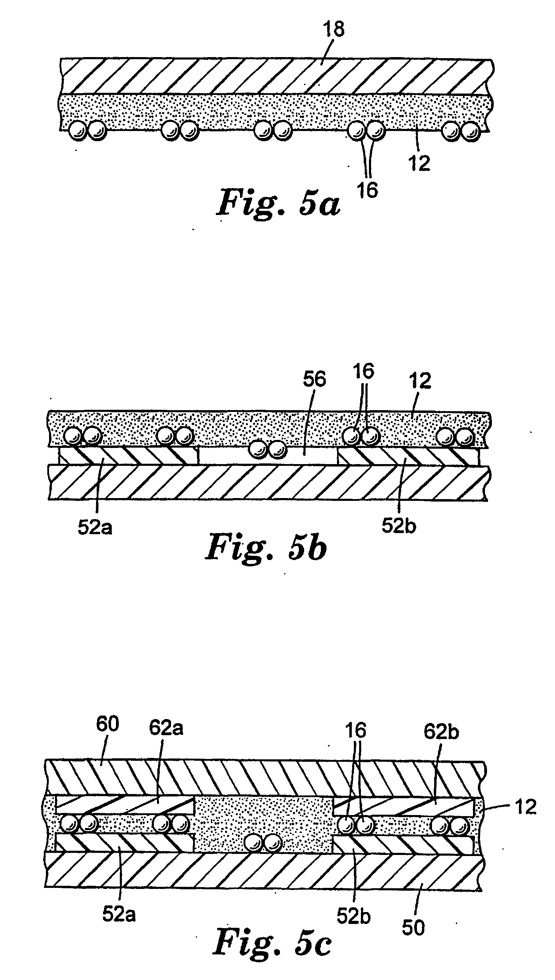

Figs. 5(a) through (c) show various steps in a method of electrically connecting two circuit layers using the anisotropic conductive adhesive of the present invention. Fig. 5(a) shows an anisotropic conductive adhesive according to the present invention having conductive particles 16 adhered to adhesive layer 12 which is laminated to optional backing film 18. The construction shown is Fig. 5(a) is used as an illustrative example. Other configurations may also be used, examples of which are shown in Figs. 1 through 3. While it is convenient to use a construction having a backing film, it is not necessary to use such a construction.

The anisotropic conductive adhesive of the present invention is then brought into contact with electrodes 52a and 52b of circuit layer 50 as shown in Fig. 5(b). Because the conductive particles are evenly distributed across the conductive adhesive, there is no need to align the adhesive with the electrodes of the circuit layer. Pressure may be applied to the backing of the conductive adhesive. The application of pressure tends to embed the conductive particles resting on the electrodes into the adhesive layer so that the adhesive layer contacts the electrode surfaces and conforms somewhat to the profile of the circuit layer and electrode pattern. The application of the conductive adhesive creates void areas between the electrodes such as void 56. At this point, the backing film, if any, is removed.

After removal of any optional backing film, second circuit layer 60 having electrodes 62a and 62b is positioned with its electrode pattern aligned with and facing the electrode pattern of circuit layer 50. Circuit layer 60 is then placed in contact with the exposed adhesive layer. Pressure may then be applied to circuit layer 60 to deform the adhesive layer until electrodes 62a and 62b make electrical contact with the conductive particles that contact electrodes pairs 52a and 52b. Optionally, heat may also be applied to help soften the adhesive layer so that it deforms more easily under pressure.

Conductive particles may be used that are at least somewhat deformable under the application of pressure, although still harder than the adhesive layer material. This ensures that small size variations among the particles are tolerated. When deformable particles are employed, larger particles that first come into contact with both electrodes in an electrode pair are capable of being vertically compressed until smaller particles are also capable of making electrical contact. This increases the reliability of the overall electrical connection by ensuring as many conductive pathways as possible.

Because the conductive particles are smaller than the thickness of the adhesive layer, adhesive layer material between the electrode pairs must be pushed out into the void areas between the electrodes. This excess adhesive layer material tends to fill the voids such as void 56 as shown in Fig. 5(c). The filling of the voids with excess adhesive layer material promotes adhesion by increasing the surface area of bonding. It also prevents shorting by ensuring that the voids are filled with insulating material. In addition, because adhesive layer material is pushed into each void from both sides of the void, any conductive particles residing in the void between electrodes tend to be pushed away from the electrodes, resulting in a "washing away" effect that reduces the possibility of particles or particle strings forming in the space between electrodes that can lead to shorting.

Because the conductive particles reside in a single layer on the adhesive layer, each conductive pathway between electrodes is through a single particle. This minimizes the number of contact surfaces that may increase the resistance of the connection. It also creates multiple single-particle pathways for a given electrode pair, thereby introducing redundancy that increases reliability.

### Examples

The examples below illustrate various specific embodiments of the present invention and should not be read to limit the scope of the invention or of the recited claims.

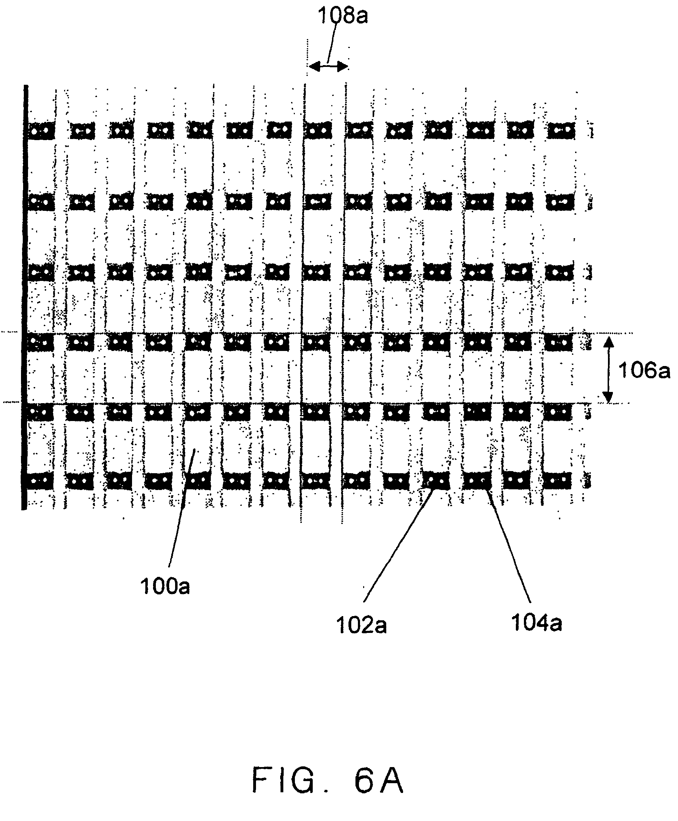

Each of Figs. 6(a) through (e) are micrographs taken of dimpled tools of the present invention subsequent to filling the dimples of the tools with conductive particles according to the method of the present invention. Each micrograph shows a tool having a periodic rectangular array of dimples filled with conductive particles. The size of the dimples, the size of the dimple array, and the particle type were varied. In each case, the depth of the dimples is such that the particles reside in the dimples in a single layer. The various dimple patterns and particle types and size distributions gave rise to different numbers of particle per particle site for each pattern. However, in all cases, no particles were observed to reside on the areas of the tool between the dimples.

Fig. 6(a) shows tool 100a having dimples 102a arranged in a rectangular array. Particles 104a are gold-coated polymeric spheres having average diameters of 4.9 µm. The distribution of particles sizes was small in order to obtain a highly uniform filling of dimples across the tool. Indeed, the vast majority of the dimples contain exactly two particles, although the occasional dimple contained three particles, and a few dimples contained one or no particles. The spacing of the dimple pattern is about 25 µm in the single particle direction 106a, and about 15 µm in the two-particle direction 108a.

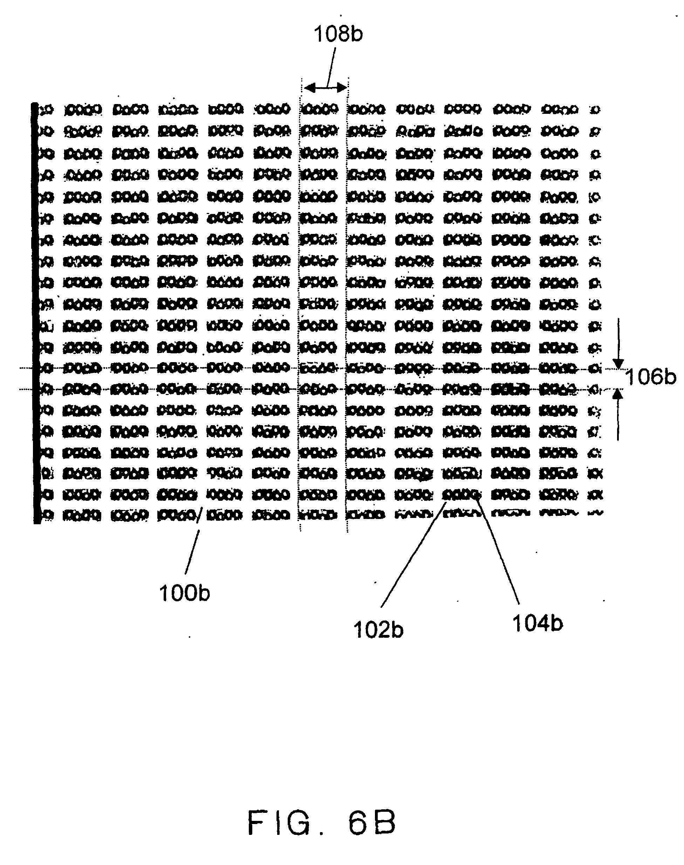

Fig. 6(b) shows tool 100b having dimples 102b arranged in a rectangular array. Particles 104b are gold-coated polymeric spheres having average diameters of 4.9 µm. The distribution of particles sizes was small in order to obtain a highly uniform filling of dimples across the tool. The dimples are sized to contain four particles in a single row. The vast majority of the dimples contained exactly four particles, although a few dimples were observed that had two, three, or five particles. The spacing of the dimple pattern is about 15 µm in the single particle direction 106b, and about 35 µm in the four-particle direction 108b.

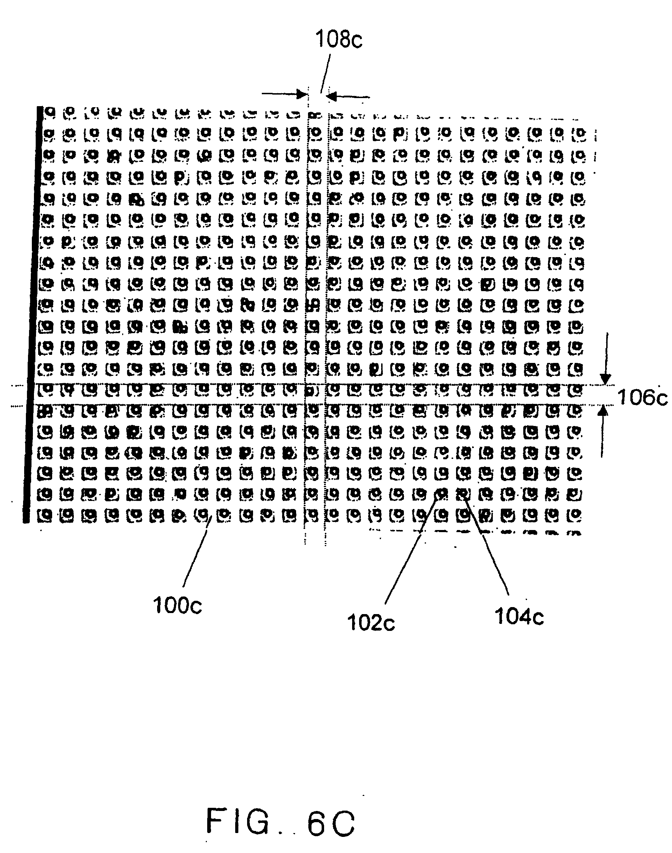

Fig. 6(c) shows tool 100c having dimples 102c arranged in a square array. Particles 104c are gold-coated polymeric spheres having average diameters of 4.9 µm. The distribution of particles sizes was small in order to obtain a highly uniform filling of dimples across the tool. The dimples are sized to contain one particle per particle site. The vast majority of the dimples contained exactly one particle, although a few dimples were observed that had two particles or no particles. The spacing of the dimple pattern is about 15 µm in both directions 106c and 108c.

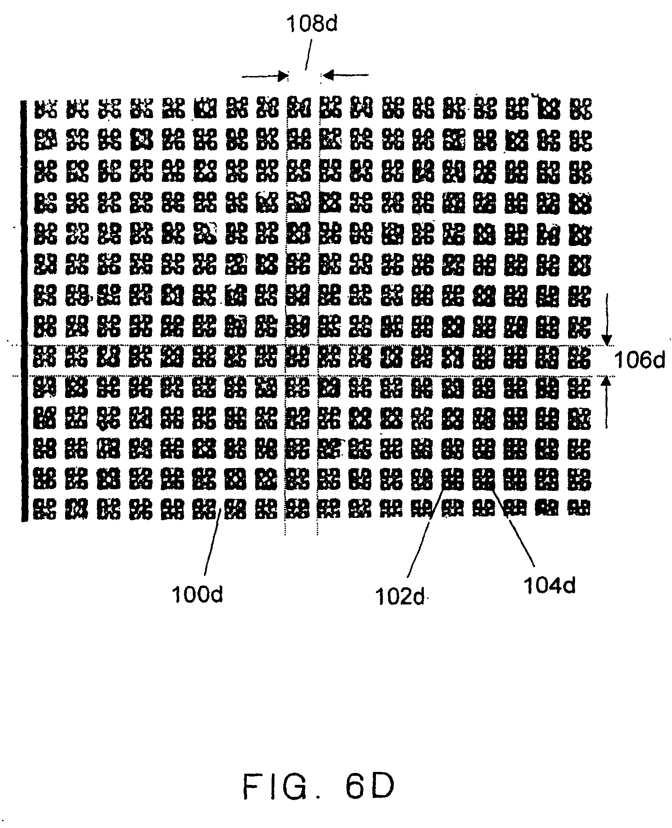

Fig. 6(d) shows tool 100d having dimples 102d arranged in a square array. Particles 104d are gold-coated polymeric spheres having average diameters of 4.9 µm. The distribution of particles sizes was small in order to obtain a highly uniform filling of dimples across the tool. The dimples are sized to contain four or five particles per particle site. The vast majority of the dimples contained either four or five particles, although a few dimples were observed that had two or three particles. The spacing of the dimple pattern is about 25 µm in both directions 106d and 108d.

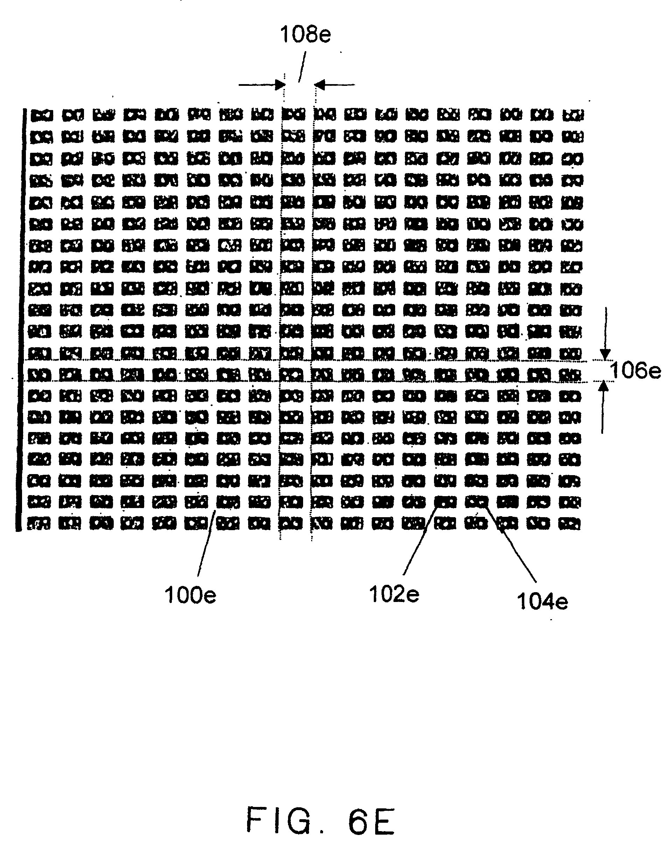

Fig. 6(e) shows tool 100e having dimples 102e arranged in a rectangular array. Particles 104e are roughly spherical nickel particles having average diameters of about 4 µm, although the overall particle size distribution was quite large. Fig. 6(e) shows how a large particle size distribution can affect filling of the dimples. While the dimples are sized to contain two 4.9 µm diameter particles, many dimples contained more than two particles in a single layer because smaller particles could be swept into the gaps between the larger particles already in the dimples during filling. The vast majority of the dimples contained from two to seven particles. The spacing of the dimple pattern is about 15 µm in the short direction 106e and about 25 µm in the long direction 108e.

## Claims

1. An anisotropic conductive adhesive (10) comprising:
(a) an adhesive layer (12) having a substantially uniform thickness, and
(b) a plurality of conductive particles (16) having sizes at least somewhat smaller than the thickness of the adhesive layer, each particle individually adhered to the adhesive layer,
wherein the plurality of conductive particles comprises a periodic array of particle sites (14), a substantial proportion of the particle sites having no more than a predetermined maximum number of residing particles, the particles residing at any particular particle site being positioned in close proximity.

2. The anisotropic conductive adhesive of claim 1, wherein a substantial proportion of the particle sites has the same number of particles.

3. The anisotropic conductive adhesive of claim 1, wherein the particles are substantially the same size and/or substantially spherical.

4. The anisotropic conductive adhesive of claim 1, wherein the particles are substantially smaller than the thickness of the adhesive layer.

5. The anisotropic conductive adhesive of claim 1, wherein the adhesive layer is capable of softening under the application of heat or pressure.

6. A method for making an electrical connection comprising the steps of:
providing a first circuit layer (50) having a first plurality of conductive contact sites (52a,52b),
providing a second circuit layer (60) having a second plurality of conductive contact sites (62a,62b),
positioning the first circuit layer (50) and second circuit layer (60) to align the first plurality of contact sites (52a,52b) with the second plurality of contact sites (62a,62b), thereby forming a plurality of contact site pairs, providing an anisotropic conductive adhesive comprising:
(a) an adhesive layer (12) having a substantially uniform thickness, and
(b) a plurality of conductive particles (16) having sizes at least somewhat smaller than the thickness of the adhesive layer, each particle Individually adhered to the adhesive layer,
wherein the plurality of conductive particles comprises a periodic array of particle sites (14), a substantial proportion of the particle sites (14) having no more than a pre-determined maximum number of residing particles (16), the particles residing at any particular particle site (14) being positioned in close proximity,
disposing the anisotropic conductive adhesive tape between the contact sites of the circuit layers (50,60), and
applying pressure to the circuit layers (50,60) until at least a substantial number of the conductive contact site pairs form isolated electrical connections, each connection via at least one conductive particle.

7. The method of claim 6, wherein during the step of applying pressure, conductive particles disposed between contact site pairs are pushed through the adhesive layer to make contact with both contact sites in a contact site pair.

## Patentansprüche

1. Anisotroper leitender Haftvermittler (10) mit:
(a) einer Haftvermittlerschicht (12) mit im wesentlichen gleichförmiger Dicke, und
(b) mehreren leitenden Partikeln (16), deren Größen mindestens etwas kleiner sind als die Dicke der Haftvermittlerschicht, wobei jeder Partikel einzeln an der Haftvermittlerschicht anhaftet,
wobei die mehreren leitenden Partikel ein periodisches Array von Partikelstellen (14) aufweisen, ein wesentlicher Anteil der Partikelstellen nicht mehr als eine vorbestimmte maximale Anzahl an ihnen angeordneter Partikel aufweist, und die an irgendeiner bestimmten Partikelstelle angeordneten Partikel in enger gegenseitiger Nähe positioniert sind.

2. Anisotroper leitender Haftvermittler nach Anspruch 1, bei dem ein wesentlicher Anteil der Partikelstellen die gleiche Anzahl von Partikeln aufweist.

3. Anisotroper leitender Haftvermittler nach Anspruch 1, bei dem die Partikel im wesentlichen die gleiche Größe haben und/oder im wesentlichen sphärisch sind.

4. Anisotroper leitender Haftvermittler nach Anspruch 1, bei dem die Partikel wesentlich kleiner sind als die Dicke der Haftvermittlerschicht.

5. Anisotroper leitender Haftvermittler nach Anspruch 1, bei dem die Haftvermittlerschicht bei Aufbringung von Wärme oder Druck erweichbar ist.

6. Verfahren zur Herstellung einer elektrischen Verbindung, mit den folgenden Schritten:
Bereitstellen einer ersten Schaltungsschicht (50) mit einer ersten Anzahl leitender Kontaktstellen (52a,52b),
Bereitstellen einer zweiten Schaltungsschicht (60) mit einer zweiten Anzahl leitender Kontaktstellen (62a,62b),
Positionieren der ersten Schaltungsschicht (50) und der zweiten Schaltungsschicht (60) zur Ausrichtung der ersten Anzahl von Kontaktstellen (52a,52b) mit der zweiten Anzahl von Kontaktstellen (62a,62b), um dadurch mehrere Kontaktstellenpaare zu bilden,
Vorsehen eines anisotropen leitenden Haftvermittlers mit:
(a) einer Haftvermittlerschicht (12) mit im wesentlichen gleichförmiger Dicke, und
(b) mehreren leitenden Partikeln (16), deren Größen mindestens etwas kleiner sind als die Dicke der Haftvermittlerschicht, wobei jeder Partikel einzeln an der Haftvermittlerschicht anhaftet,
wobei die mehreren leitenden Partikel ein periodisches Array von Partikelstellen (14) aufweisen, ein wesentlicher Anteil der Partikelstellen (14) nicht mehr als eine vorbestimmte maximale Anzahl an ihnen angeordneter Partikel (16) aufweist, und die an irgendeiner bestimmten Partikelstelle (14) angeordneten Partikel in enger gegenseitiger Nähe positioniert sind,
Anordnen des anisotropen leitenden Haftvermittlerbandes zwischen den Kontaktstellen der Schaltungsschichten (50,60), und
Aufbringen von Druck auf die Schaltungsschichten (50,60), bis mindestens eine wesentliche Anzahl der Paare leitender Kontaktstellen eine isolierte elektrische Verbindung bildet, wobei jede Verbindung über mindestens einen leitenden Partikel gebildet wird.

7. Verfahren nach Anspruch 6, bei dem während des Schritts des Druckaufbringens zwischen den Kontaktstellen-Paaren angeordnete leitende Partikel durch die Haftvermittlerschicht gedrückt werden, um einen Kontakt mit beiden Kontaktstellen eines Kontaktstellen-Paars herzustellen.

## Revendications

1. Adhésif conducteur anisotrope (10) comprenant :
(a) une couche adhésive (12) ayant une épaisseur essentiellement uniforme, et
(b) une multiplicité de particules conductrices (16) ayant des tailles au moins légèrement inférieures à l'épaisseur de la couche adhésive, chaque particule adhérant individuellement à la couche adhésive,
dans lequel la multiplicité de particules conductrices comprend un réseau périodique de sites de particules (14), une portion substantielle des sites de particules n'ayant pas plus d'un nombre maximum prédéterminé de particules résidantes, les particules résidant à un site particulier de particules étant positionnées en étroite proximité.

2. Adhésif conducteur anisotrope selon la revendication 1, dans lequel une proportion substantielle des sites de particules a le même nombre de particules.

3. Adhésif conducteur anisotrope selon la revendication 1, dans lequel les particules sont essentiellement de taille identique et/ou essentiellement sphériques.

4. Adhésif conducteur anisotrope selon la revendication 1, dans lequel les particules sont essentiellement plus petites que l'épaisseur de la couche adhésive.

5. Adhésif conducteur anisotrope selon la revendication 1, dans lequel la couche adhésive est capable de ramollissement par application de chaleur ou de pression.

6. Procédé de fabrication d'une connexion électrique comprenant les étapes consistant à :
prendre une première couche de circuit (50) ayant une première multiplicité de sites de contact conducteurs (52a, 52b),
prendre une seconde couche de circuit (60) ayant une seconde multiplicité de sites de contact conducteurs (62a, 62b),
positionner la première couche de circuit (50) et la seconde couche de circuit (60) pour aligner la première multiplicité de sites de contact (52a, 52b) avec la seconde pluralité de sites de contact (62a, 62b), formant par-là une multiplicité de paires de sites de contact, fournissant un adhésif conducteur anisotrope comprenant :
(a) une couche adhésive (12) ayant une épaisseur essentiellement uniforme, et
(b) une multiplicité de particules conductrices (16) ayant des tailles au moins légèrement inférieures à l'épaisseur de la couche adhésive, chaque particule adhérant individuellement à la couche adhésive,
dans lequel la multiplicité de particules conductrices comprend un réseau périodique de sites de particules (14), une portion substantielle des sites de particules (14) n'ayant pas plus d'un nombre maximum prédéterminé de particules résidantes (16), les particules résidant à un site particulier (14) de particules étant positionnées en étroite proximité,
disposer le ruban adhésif conducteur anisotrope entre les sites de contact des couches de circuit (50, 60), et
appliquer de la pression aux couches de circuit (50, 60) jusqu'à ce qu'au moins un nombre substantiel des paires de sites de contact conducteurs forme des connexions électriques isolées, chaque connexion passant au moins par une particule conductrice.

7. Procédé selon la revendication 6, dans lequel pendant l'étape d'application de pression, des particules conductrices disposées entre des paires de sites de contact sont poussées à travers la couche adhésive pour faire contact avec les deux sites de contact en une paire de sites de contact.
